# EUROPÄISCHE PATENTSCHRIFT

(11) **EP 1 921 910 B1**
(45) Veröffentlichungstag und Bekanntmachung des Hinweises auf die Patenterteilung: **08.08.2012**
(21) Anmeldenummer: 07021365.7
(22) Anmeldetag: 02.11.2007
(51) Int. Cl.: H05K 3/32, H05K 5/06

(54) **Schaltungsanordnung mit einem Leistungsmodul, das mit einer Leiterplatte kombiniert ist**
Circuit with a power module that is combined with a circuit board
Circuit avec un module de puissance combiné à une carte à circuit

(30) Priorität: 08.11.2006 DE 102006052620
(43) Veröffentlichungstag der Anmeldung: 14.05.2008
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A- 1 592 063
- DE-A1- 19 630 173
- DE-A1-102005 024 900
- JP-A- 2005 217 075
- US-B1- 6 417 747

## Beschreibung

Die Erfindung betrifft eine Schaltungsanordnung mit einem Leistungsmodul, das mit einer Leiterplatte kombiniert ist, wobei das Leistungsmodul und die Leiterplatte zwischen einem Kühlkörper und einer Preßeinrichtung vorgesehen und miteinander durch Druckkontahsalemense druckkontaktiert sind, wobei das Leistungsmodul mindestens ein Modulplattenelement und ein Gehäuse aufweist, das mit Schächten für Druckkontaktelemente ausgebildet ist, die mit dem mindestens einem Modulplattenelement kontaktiert sind und aus der der Leiterplatte zugewandten Grundfläche des Gehäuses an Mündungsöffnungen ausmünden, um das Leistungsmodul mit der Leiterplatte zu kontaktieren.

Aus der DE 196 30 173 A1 ist ein Leistungsmodul bekannt, das ein Gehäuse mit Druckkontaktelementen aufweist. Die Druckkontaktelemente sind zur Kontaktierung eines Modul-Plattenelementes mit einer kundenspezifischen Leiterplatte vorgesehen. Bei derartigen Schaltungsanordnungen kann nicht zuverlässig ausgeschlossen werden, daß es unter extremen Klimabedingungen, wie bspw. einer extremen Feuchtebeaufschlagung mit zwischenzeitlicher Betauung, zu einem Ausfall, insbesondere durch eine korrosion des Schaltungsmoduls der Druckkontaktelemente und/oder der Leiterplatte kommt.

Die EP 1 592 063 A2 offenbart eine Schaltungsanordnung mit einem Leistungshalbleitermodul, das mit einer Leiterplatte kombiniert ist, und einer Kühleinrichtung. Das Leistungshalbleitermodul weist Kontaktelemente auf, die die Leiterplatte und das Leistungshalbleitermodul druckkontaktieren.

In der DE 10 2005 024 900 A1 wird eine Schaltungsanordnung mit einem Leistungsmodul offenbart, das mit einer Leiterplatte kombiniert ist. Die Leiterplatte und das Leistungsmodul sind zwischen einem Kühlkörper und einer Presseinrichtung vorgesehen und durch Druckkontaktierungselemente druckkontaktiert. Das Leistungsmodul weist einen Modul-Plattenelement und ein Gehäuse auf, das mit Schächten für die Druckkontaktelemente ausgebildet ist.

Aus der US 6 417 747 B1 wird ein Modul mit einem Gehäuse und einem PWB beschrieben, bei dem das Gehäuse mittels einer Klebevorrichtung mit dem PWB befestigt wird. Weiterhin weist das Gehäuse Pins auf, die für eine zusätzliche Verbindung im PWB befestigt werden. Hierfür weist die Klebevorrichtung und das PWB Ausnehmungen auf. Dieklebevorrichtung ist bevorzugt eine klebeschicht, ein klebefilm, beonders bevorzugt doppelseitig klebend.

Die JP 2005217075 A beschreibt eine Anordnung, bei der Vibrationen und Belastungen auf eine Leiterplatte vermieden werden sollen. Das erfolgt mittels einem oberen und einem unteren Gehäuse, die die Leiterplatte einklemmen. Zusätzlich wird auf oder unter die Leiterplatte ein Dichtungselement angeordnet, das elastisch ausgelegt ist.

Der Erfindung liegt die Aufgabe zugrunde, eine Schaltungsanordnung der eingangs genannten Art zu schaffen, bei der mit einfachen Mitteln eine Korrosion des Leistungsmoduls, der Druckkontaktelemente und/oder der Leiterplatte verhindert und ein daraus resultierender Ausfall der Schaltungsanordnung vermieden wird.

Diese Aufgabe wird bei einer Schaltungsanordnung der eingangs genannten Art erfindungsgemäß dadurch gelöst, daß zwischen der Leiterplatte und der der Leiterplatte zugewandten Grundfläche des Gehäuses ein Abdichtflächenelement vorgesehen ist, das mit Ausnehmungen für die Druckkontaktelemente ausgebildet ist.

Mit Hilfe des Abdichtflächenelementes zwischen der Leiterplatte und der Grundfläche des Gehäuses des Leistungsmoduls ergibt sich der Vorteil, daß ein Eindringen von Feuchtigkeit verhindert und folglich Korrosionen an der Leiterplatte, den Druckkontaktelementen und/oder am Leistungsmodul vermieden werden. Die erfindungsgemäße Schaltungsanordnung besitzt folglich eine optimale Zuverlässigkeit bzw. Betriebseigenschaften.

Das Abdichtflächenelement ist bei der erfindungsgemäßen Schaltungsflächenanordnung zweckmäßigerweise mit Außenabmessungen ausgebildet, die den Randabmessungen der Grundfläche des Gehäuses entsprechen, d.h. an diese abmessungsgemäß angepaßt sind.

Das Abdichtflächenelement ist vorzugsweise von einer Kunststoffolie gebildet. Dabei kann es sich bspw. um eine PTFE-Folie handeln, die im Temperaturbereich zwischen -20 und + 260 °C einsetzbar ist, die säure-, laugen-, benzin- und ölbeständig und die außerdem unbrennbar ist, und insofern dem Brandverhalten UL 94 VO entspricht.

Selbstverständlich kann das Abdichtflächenelement auch aus einem anderen geeigneten Material bestehen.

Gute Abdichteigenschaften werden bei der erfindungsgemäßen Schaltungsanordnung erzielt, wenn die Grundfläche des Gehäuses entlang ihres Außenrandes eine umlaufende Randdichtrippe aufweist. Im zusammengebauten Zustand der erfindungsgemäßen Schaltungsanordnung, ist diese umlaufende Randdichtrippe in das Abdichtflächenelement eingepreßt, wodurch optimale Abdichteigenschaften erzielt werden.

Die umlaufende Randdichtrippe kann aus dem Material des Gehäuses bestehen, d.h. mit dem Gehäusematerial einstückig ausgebildet sein. Eine andere Möglichkeit besteht darin, daß die umlaufende Randdichtrippe aus einem nachgiebigen Material besteht und an der Grundfläche des Gehäuses vorgesehen ist. Eine derartige Randdichtrippe der zuletzt genannten Art kann bspw. auf die Grundfläche des Gehäuses nachträglich aufgedruckt werden; eine andere Möglichkeit besteht darin, das Gehäuse in einem 2K-Spritzverfahren herzustellen, wobei das Gehäuse aus einer harten Komponente und die Randdichtrippe aus einer nachgiebigen Komponente, d.h. aus dem nachgiebigen Material besteht.

Unabhängig davon, ob die umlaufende Randdichtrippe mit dem Gehäusematerial einstückig aus demselben Material oder ob die Randdichtrippe aus einem nachgiebigen Material und das Gehäuse aus einem formstabilen harten Material besteht, ergibt sich durch die umlaufende Randdichtrippe der Vorteil einer guten Abdichtung zwischen der Grundfläche des Gehäuses und der zu dieser benachbarten und durch das Abdichtflächenelement beabstandeten Leiterplatte.

Weiter verbesserte Abdichteigenschaften ergeben sich bei der erfindungsgemäßen Schaltungsanordnung, wenn die Grundfläche des Gehäuses um die Mündungsöffnungen der für die Druckkontaktelemente vorgesehenen Schächte herum mit Öffnungsdichtrippen ausgebildet sind. Diese Öffnungsdichtrippen können einzelnen Mündungsöffnungen und/oder Gruppen von Mündungsöffnungen zugeordnet sein. Dabei können die Öffnungsdichtrippen - wie die um den Außenrand der Grundfläche des Gehäuses umlaufende Randdichtrippe aus dem Material des Gehäuses bestehen, und mit diesem integral ausgebildet sein, oder die Öffnungsdichtrippen können aus einem nachgiebigen Material bestehen und an der Grundfläche des Gehäuses vorgesehen sein. Die Öffnungsdichtrippen können hierbei wie die Randdichtrippe auf die Grundfläche des Gehäuses aufgedruckt oder in einem 2K-Spritzverfahren während eines gemeinsamen Kunststoffspritzprozesses realisiert werden.

Durch das Abdichtflächenelement zwischen der Leiterplatte und der Grundfläche des Gehäuses ergibt sich - wie ausgeführt worden ist - eine gute Abdichtung, so daß eine Korrosion der Leiterplatte, der Druckkontaktelemente und/oder des Leistungsmoduls verändert wird. Durch die umlaufende Randdichtrippe bzw. die Öffnungsdichtrippen, die im zusammengebauten Zustand der Schaltungsanordnung in das Abdichtflächenelement abdichtend eingepreßt sind, wird die Abdichtung der Schaltungsanordnung weiter wesentlich verbessert. Die erfindungsgemäß ausgebildete Schaltungsanordnung besitzt folglich optimale Eigenschaften gegen eine feuchtigkeitsbedingte Korrosion der Leiterplatte, der Druckkontaktelemente und/oder des Leistungsmoduls.

Weitere Einzelheiten, Merkmale und Vorteile ergeben sich aus der nachfolgenden Beschreibung eines in der Zeichnung schematisch verdeutlichten Ausführungsbeispieles der erfindungsgemäßen Schaltungsanordnung bzw. wesentlicher Einzelheiten derselben.

Es zeigen:
- Figur 1: abschnittsweise in einer Seitenansicht nicht maßstabgetreu eine Ausführungsform der Schaltungsanordnung,
- Figur 2: eine Ansicht in Blickrichtung der Pfeile II-II in Figur 1 auf einen Abschnitt der Grundfläche des Gehäuses der Schaltungsanordnung,
- Figur 3: eine der Figur 2 ähnliche abschnittsweise Draufsicht auf eine andere Ausbildung des Gehäuses,
- Figur 4: einen Schnitt entlang der Schnittlinie IV-IV in Figur 2 in einem größeren Maßstab,
- Figur 5: einen Schnitt entlang der Schnittlinie V-V in Figur 2 in einem der Figur 4 ähnlichen vergrößerten Maßstab,
- Fig. 6: eine perspektivische Ansicht einer Ausbildung des Abdichtflächenelementes,
- Fig. 7: eine Draufsicht auf das Abdichtflächenelement gemäß Figur 6,
- Fig. 8: eine perspektivische Ansicht einer Ausbildung des becherförmigen Gehäuses in Blickrichtung auf seine Grundfläche, und
- Fig. 9: eine Ansicht des becherförmigen Gehäuses gemäß Figur 8 in Blickrichtung von oben.

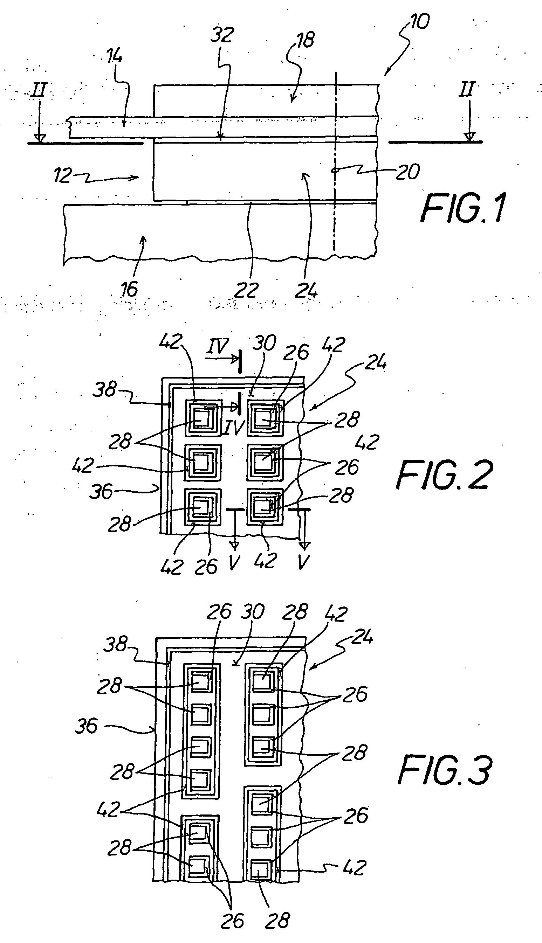

Figur 1 verdeutlicht schematisch abgeschnitten in einer Seitenansicht die Schaltungsanordnung 10 mit einem Leistungsmodul 12, das mit einer Leiterplatte 14 kombiniert ist. Das Leistungsmodul 12 und die Leiterplatte 14 sind zwischen einem abgeschnitten gezeichneten Kühlkörper 16 und einer Preßeinrichtung 18 vorgesehen und miteinander in an sich bekannter Weise druckkontaktiert. Zum Verpressen der Leiterplatte 14 mit dem Leistungsmodul 12 wird die Preßeinrichtung 18 mit dem Kühlkörper 16 verspannt. Dieses Verspannen erfolgt bspw. mit Hilfe mindestens einer Schraube, die in Figur 1 durch eine strichpunktierte Linie 20 schematisch angedeutet ist.

Das Leistungsmodul 12 weist in bekannter Weise mindestens ein Modulplattenelement 22 und ein becherförmiges Gehäuse 24 auf. Das becherförmige Gehäuse 24 ist mit Schächten 26 (sh. die Figuren 2, 3, 5, 8 und 9) ausgebildet. Die Schächte 26 sind für Druckkontaktelemente 28 vorgesehen, wie sie ebenfalls in den Figuren 2, 3, 5 und 9 verdeutlicht sind.

Die Druckkontaktelemente 28 sind zur Druckkontaktierung des mindestens einen Modulplattenelementes 22 mit der Leiterplatte 14 vorgesehen.

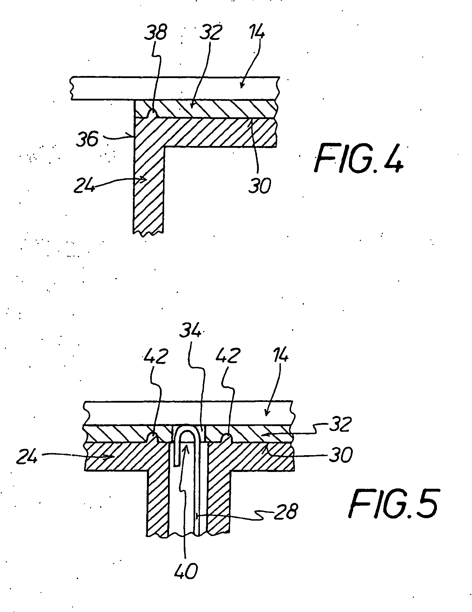

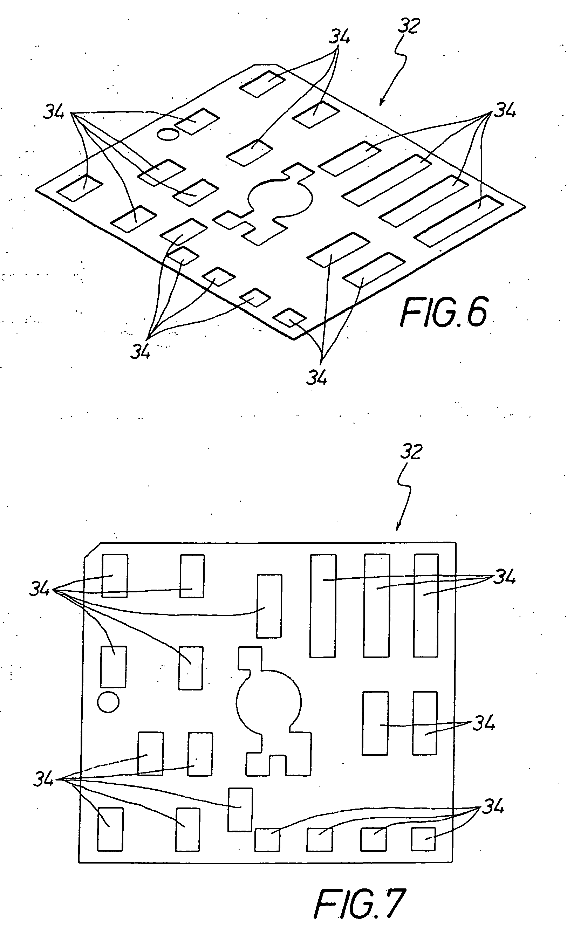

Um zwischen dem Leistungsmodul 12 und der Leiterplatte 14 eine sichere Abdichtung zu bewirken, ist zwischen der Leiterplatte 14 und der der Leiterplatte zugewandten Grundfläche 30 des vorzugsweise becherförmig ausgebildeten Gehäuses 24 ein Abdichtflächenelement 32 vorgesehen. Das Abdichtflächenelement 32 ist mit Ausnehmungen 34 (siehe insbesondere der Figuren 6 und 7) für die Druckkontaktelemente 28 ausgebildet. In Figur 5 ist eine dieser Ausnehmungen 34 verdeutlicht.

Wie aus den Figuren 2, 4, 8 und 9 ersichtlich ist, ist die Grundfläche 30 des becherförmigen Gehäuses 24 entlang ihres Außenrandes 36 mit einer umlaufenden Randdichtrippe 38 ausgebildet. Eine entsprechende Randdichtrippe 38 ist auch in Figur 3 verdeutlicht.

Mit Hilfe der Randdichtrippe 38, die im zusammengebauten Zustand der Schaltungsanordnung 10 in das Abdichtflächenelement 32 eingepreßt ist, ergibt sich eine Verbesserung der primär durch das Abdichtflächenelement 32 bewirkten Abdichtung der Schaltungsanordnung 10, so daß ein Eindringen von Feuchtigkeit und eine daraus resultierende Korrosion der Leiterplatte 14, der Druckkontaktelemente 28 und/oder des Modulplattenelementes 22 verhindert wird. Diese Abdichtung wird noch weiter verbessert, wenn die Grundfläche 30 des becherförmigen Gehäuses 24 um die Mündungsöffnungen 40 (sh. die Figuren 5, 8 und 9) der für die Druckkontaktelemente 28 vorgesehenen Schächte 26 herum mit Öffnungsdichtrippen 42 ausgebildet ist. Die Öffnungsdichtrippen 42 können einzelnen Mündungsöffnungen 40 zugeordnet sein, wie Figur 2 zeigt, oder die Öffnungsdichtrippen 42 sind Gruppen von Mündungsöffnungen 26 zugeordnet, wie die Figuren 3, 8 und 9 zeigen. Durch diese Öffnungsdichtrippen 42 ergibt sich eine weitere Verbesserung der Abdichtung der Schaltungsanordnung 10 gegen ein Eindringen von Feuchtigkeit und eine dadurch bedingte Korrosion der Leiterplatte 14 des mindestens einen Modulplattenelementes 22 und der Druckkontaktelemente 28 zwischen diesen.

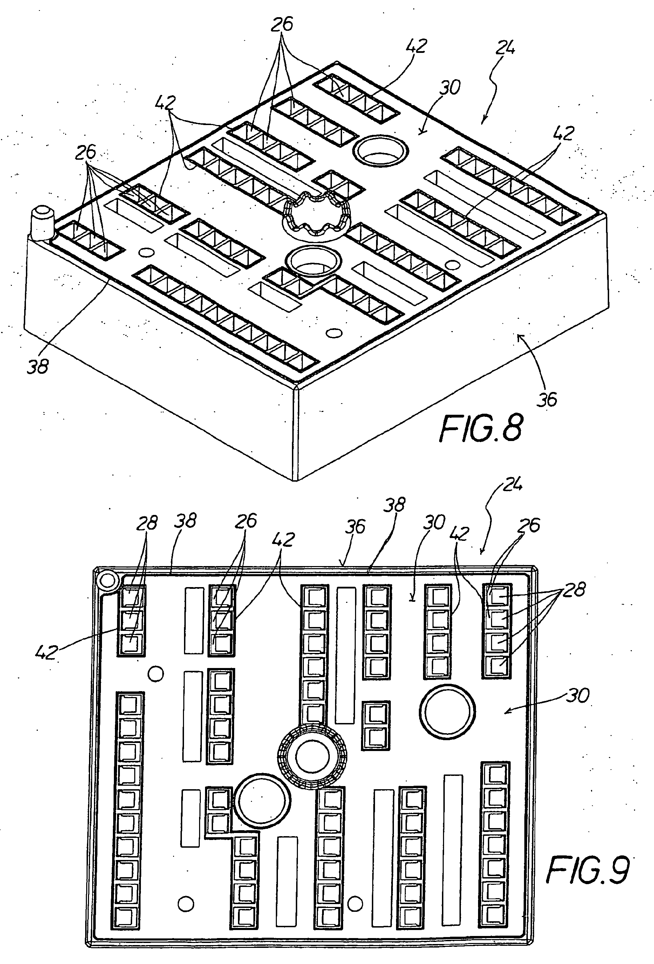

Die Figuren 6 und 7 zeigen eine Ausführungsform des Abdichtflächenelementes 32 in einer räumlichen Ansicht und in einer Draufsicht mit den Ausnehmungen 34 für Druckkontaktelemente 28 (sh. bspw. Figur 9).

Die Figuren 8 und 9 zeigen eine Ausbildung eines becherförmigen Gehäuses 24 in einer räumlichen Ansicht von schräg oben und in einer Draufsicht mit den Schächten 26 für Druckkontaktelemente 28 und mit der um den Außenrand 36 der Grundfläche 30 des Gehäuses 24 umlaufenden Randdichtrippe 38 und den um Gruppen von Schächten 26 bzw. Mündungsöffnungen der Schächte 26 gruppenweise umlaufenden Öffnungsdichtrippen 42.

### Bezugsziffernliste:

- 10: Schaltungsanordnung
- 12: Leistungsmodul (von 10)
- 14: Leiterplatte (von 10
- 16: Kühlkörper (für 12)
- 18: Preßeinrichtung (für 14 und 12)
- 20: strichpunktierte Linie/Schraube (zwischen 18 und16)
- 22: Modulplattenelement (von 12 an 16)
- 24: becherförmiges Gehäuse (von 12 für 22)
- 26: Schächte (in 24 für 28)
- 28: Druckkontaktelemente (zwischen 12 bzw. 22 und 14)
- 30: Grundfläche (von 24)
- 32: Abdichtflächenelement (zwischen 12 und 14)
- 34: Ausnehmungen (in 32 für 28)
- 36: Außenrand (von 30)
- 38: Randdichtrippe (an 36)
- 40: Mündungsöffnungen (von 26 an 30)
- 42: Öffnungsdichtrippen (um 40)

## Patentansprüche

1. Schaltungsanordnung (10) mit einem Leistungsmodul (12), das mit einer Leiterplatte (14) kombiniert ist, wobei das Leistungsmodul (12) und die Leiterplatte (14) zwischen einem Kühlkörper (16) und einer Preßeinrichtung (18) vorgesehen und miteinander durch Druckkontaktelemente (28) druckkontaktiert sind, wobei das Leistungsmodul (12) mindestens ein Modulplattenelement (22) und ein Gehäuse (24) aufweist, das mit Schächten (26) für die Druckkontaktelemente (28) ausgebildet ist, die mit dem mindestens einem Modulplattenelement (22) des Leistungsmoduls (12) kontaktiert sind und aus der der Leiterplatte (14) zugewandten Grundfläche (30) des Gehäuses (24) an Mündungsöffnungen (40) ausmünden,
**dadurch gekennzeichnet,**
**daß** zwischen der Leiterplatte (14) und der Grundfläche (30) des Gehäuses (4) ein Abdichtflächenelement (32) vorgesehen ist, das mit Ausnehmungen (34) für die Druckkontaktelemente (28) ausgebildet ist.

2. Schaltungsanordnung nach Anspruch 1,
**dadurch gekennzeichnet,**
**daß** das Abdichtflächenelement (32) mit Außenabmessungen ausgebildet ist, die den Randabmessungen der Grundfläche (30) des Gehäuse (24) entsprechen.

3. Schaltungsanordnung nach Anspruch 1,
**dadurch gekennzeichnet,**
**daß** das Abdichtflächenelement (32) von einer Kunststoffolie gebildet ist.

4. Schaltungsanordnung nach Anspruch 1,
**dadurch gekennzeichnet,**
**daß** die Grundfläche (30) des Gehäuses (24) entlang ihres Außenrandes (36) eine umlaufende Randdichtrippe (38) aufweist.

5. Scha!tungsanordnung nach Anspruch 4,
**dadurch gekennzeichnet,**
**daß** die umlaufende Randdichtrippe (38) aus dem Material des Gehäuses (24) besteht.

6. Schaltungsanordnung nach Anspruch 4,
**dadurch gekennzeichnet,**
**daß** die umlaufende Randdichtrippe (38) aus einem nachgiebigen Material besteht und an der Grundfläche (30) des Gehäuses (24) vorgesehen ist.

7. Schaltungsanordnung nach Anspruch 1,
**dadurch gekennzeichnet,**
**daß** die Grundfläche (30) des Gehäuses (24) um die Mundungsöffnungen (40) der für die Druckkontaktelemente (28) vorgesehenen Schächte (26) herum mit Öffnungsdichtrippen (42) ausgebildet ist.

8. Schaltungsanordnung nach Anspruch 7,
**dadurch gekennzeichnet,**
**daß** die Öffnungsdichtrippen (42) einzelnen Mündungsöffnungen (40) und/oder Gruppen von Mündungsöffnungen (40) zugeordnet sind.

9. Schaltungsanordnung nach Anspruch 7 oder 8,
**dadurch gekennzeichnet,**
**daß** die Öffnungsdichtrippen (42) aus dem Material des Gehäuses (24) bestehen.

10. Schaltungsanordnung nach Anspruch 7 oder 8,
**dadurch gekennzeichnet,**
**daß** die Öffnungsdichtrippen (42) aus einem nachgiebigen Material bestehen und an der Grundfläche (30) des Gehäuses (24) vorgesehen sind.

## Claims

1. A circuit arrangement (10) with a power module (12), which is combined with a printed circuit board (14), wherein the power module (12) and the printed circuit board (14) are provided between a cooling body (16) and a pressing device (18) and pressure contacted with one another by means of pressure contact elements (28), wherein the power module (12) has at least one module panel element (22) and a housing (24) which is constructed with slots (26) for the pressure contact elements (28) which are contacted with the at least one module panel element (22) of the power module (12) and open out at the base surface (30) of the housing (24) facing the printed circuit board (14) at outlet openings (40),
**characterised**
**in that** a sealing face element (32), which is constructed with recesses (34) for the pressure contact elements (28), is provided between the printed circuit board (14) and the base surface (30) of the housing (4) facing the printed circuit board.

2. The circuit arrangement according to Claim 1,
**characterised**
**in that** the sealing face element (32) is constructed with external dimensions which correspond to the edge dimensions of the base surface (30) of the housing (24).

3. The circuit arrangement according to Claim 1,
**characterised**
**in that** the sealing face element (32) is formed from a plastic film.

4. The circuit arrangement according to Claim 1,
**characterised**
**in that** the base surface (30) of the housing (24) has a peripheral edge sealing rib (38) along its external edge (36).

5. The circuit arrangement according to Claim 4,
**characterised**
**in that** the peripheral edge sealing rib (38) consists of the material of the housing (24).

6. The circuit arrangement according to Claim 4,
**characterised**
**in that** the peripheral edge sealing rib (38) consists of a flexible material and is provided on the base surface (30) of the housing (24).

7. The circuit arrangement according to Claim 1,
**characterised**
**in that** the base surface (30) of the housing (24) is constructed using opening sealing ribs (42) around the outlet openings (40) of the slots (26) provided for the pressure contact elements (28).

8. The circuit arrangement according to Claim 7,
**characterised**
**in that** the opening sealing ribs (42) are assigned to individual outlet openings (40) and/or groups of outlet openings (40).

9. The circuit arrangement according to Claim 7 or 8,
**characterised**
**in that** the opening sealing ribs (42) consist of the material of the housing (24).

10. The circuit arrangement according to Claim 7 or 8,
**characterised**
**in that** the opening sealing ribs (42) consist of a flexible material and are provided on the base surface (30) of the housing (24).

## Revendications

1. Agencement de circuit (10) comprenant un module de puissance (12), qui est combiné avec une plaque à circuits imprimés (14), le module de puissance (12) et la plaque à circuits imprimés (14) étant prévus entre un corps réfrigérant (16) et un dispositif de compression (18) et étant mis en contact de pression l'un avec l'autre par des éléments de contact de pression (28), le module de puissance (12) présentant au moins un élément de plaque de module (22) et un boîtier (24), lequel est conçu avec des puits (26) pour les éléments de contact de pression (28), qui sont en contact avec le au moins un élément de plaque de module (22) du module de puissance (12) et débouchent de la surface de base (30), tournée vers la plaque à circuits imprimés (14), du boîtier (24) sur des orifices de débouché (40),
**caractérisé en ce**
**qu'**un élément de surface d'étanchéité (32), qui est conçu avec des évidements (34) pour les éléments de contact de pression (28), est prévu entre la plaque à circuits imprimés (14) et la surface de base (30) du boîtier (4).

2. Agencement de circuit selon la revendication 1,
**caractérisé en ce que**
l'élément de surface d'étanchéité (32) est conçu avec des dimensions extérieures qui correspondent aux dimensions de bord de la surface de base (30) du boîtier (24).

3. Agencement de circuit selon la revendication 1,
**caractérisé en ce que**
l'élément de surface d'étanchéité (32) est formé par un film en matière plastique.

4. Agencement de circuit selon la revendication 1,
**caractérisé en ce que**
la surface de base (30) du boîtier (24) présente le long de son bord extérieur (36) une nervure d'étanchéité de bord (38) périphérique.

5. Agencement de circuit selon la revendication 4,
**caractérisé en ce que**
la nervure d'étanchéité de bord (38) périphérique est à base du matériau du boîtier (24).

6. Agencement de circuit selon la revendication 4,
**caractérisé en ce que**
la nervure d'étanchéité de bord (38) périphérique est à base d'un matériau souple et est prévue sur la surface de base (30) du boîtier (24).

7. Agencement de circuit selon la revendication 1,
**caractérisé en ce que**
la surface de base (30) du boîtier (24) est conçue avec des nervures d'étanchéité d'orifice (42) tout autour des orifices de débouché (40) des puits (26) prévus pour les éléments de contact de pression (28).

8. Agencement de circuit selon la revendication 7,
**caractérisé en ce que**
les nervures d'étanchéité d'orifice (42) sont attribuées à des orifices de débouché (40) individuels et/ou des groupes d'orifices de débouché (40).

9. Agencement de circuit selon la revendication 7 ou 8,
**caractérisé en ce que**
les nervures d'étanchéité d'orifice (42) sont à base du matériau du boîtier (24).

10. Agencement de circuit selon la revendication 7 ou 8,
**caractérisé en ce que**
les nervures d'étanchéité d'orifice (42) sont à base d'un matériau souple et sont prévues sur la surface de base (30) du boîtier (24).
